# EUROPÄISCHE PATENTANMELDUNG

(11) **EP 3 118 994 A1**
(43) Veröffentlichungstag der Anmeldung: **18.01.2017**
(21) Anmeldenummer: 15176456.0
(22) Anmeldetag: 13.07.2015
(51) Int. Cl.: H03K 17/082, H03K 17/60, H03K 17/785

(54) **SCHALTMITTEL ZUM SCHALTEN EINER LAST UND AUSGABEBAUGRUPPE FÜR DIE INDUSTRIELLE AUTOMATISIERUNG**

(71) Anmelder: Siemens Aktiengesellschaft, 80333 München (DE)
(72) Erfinder: Wagner, Roman, 92224 Amberg (DE)

(57) **Zusammenfassung**

Um ein Schaltmittel (1) zum Schalten einer zwischen einer ersten Ausgangsklemme (Qa) und einer zweiten Ausgangsklemme (Qb) angeordneten Last (L) universell zu nutzen, wird zwischen den Ausgangsklemmen (Qa,Qb) in einer Reihenschaltung ein erster Feldeffekttransistor (T12), ein erster Widerstand (R12), ein zweiter Widerstand (R22) und ein zweiter Feldeffekttransistor (T22) angeordnet, wobei die Gate-Anschlüsse (G12, G22) der Feldeffekttransistoren (T12,T22) mit dem ersten Ausgangsanschluss (11) verbunden sind, wobei die Widerstände (R12, R22) in einer Reihenschaltung die Source-Anschlüsse (S12, S22) der Feldeffekttransistoren (T12, T22) verbinden, wobei ein erster Regeltransistor (T11) mit seinem Basisanschluss an dem Source-Anschluss (S12) und mit seinem Kollektor-Anschluss an dem Gate-Anschluss (G12) des ersten Feldeffekttransistors (T12) angeschlossen ist und mit seinem Emitter-Anschluss an dem Source-Anschluss (S22) des zweiten Feldeffekttransistors (T22) angeschlossen ist, wobei ein zweiter Regeltransistor (T21) mit seinem Basisanschluss an dem Source-Anschluss (S22) und mit seinem Kollektor-Anschluss an dem Gate-Anschluss (G22) des zweiten Feldeffekttransistors (T22) angeschlossen ist und mit seinem Emitter-Anschluss an dem Source-Anschluss (S12) des ersten Feldeffekttransistors (T22) angeschlossen ist, wobei der zweite Ausgangsanschluss (12) zwischen dem ersten Widerstand (R12) und dem zweiten Widerstand (R22) angeschlossen ist, wodurch eine Kurzschlussstrombegrenzung realisiert ist.

## Beschreibung

Die Erfindung betrifft zum einen ein Schaltmittel zum Schalten einer zwischen einer ersten Ausgangsklemme und einer zweiten Ausgangklemme angeordneten Last, umfassend ein Potentialtrennmittel mit einer Schaltsignal-Eingangsseite zur Trennung des Potentials zwischen der Schaltsignal-Eingangsseite und einer Schaltsignal-Ausgangsseite, wobei das Potentialtrennmittel nach dem Photovoltaik-Prinzip aufgebaut ist und durch Anlegen einer Spannung an die Schaltsignal-Eingangsseite eine Schaltspannung an der Schaltsignal-Ausgangsseite zwischen einem ersten Ausgangsanschluss und einen zweiten Ausgangsanschluss erzeugbar ist.

Zum anderen betrifft die Erfindung eine Ausgabebaugruppe für die industrielle Automatisierung mit den zuvor genannten Schaltmittel.

Ein Ziel in der Automatisierungs- und der Fertigungstechnik ist es, Schaden zu vermeiden und eine schnelle Fehlersuche zu ermöglichen, um einen Stillstand einer Fertigungsanlage zu minimieren bzw. zu vermeiden. Ein Anwender von Automatisierungsanlagen erwartet deswegen eine höhere Robustheit gegen Montagefehler, wie eine falsche Verdrahtung, die zu einem Kurzschluss führen könnte.

Es ist Aufgabe der vorliegenden Erfindung ein Schaltmittel zum Schalten einer Last bereitzustellen, bei welchem es möglich ist, einen Kurzschluss zu detektieren und gleichzeitig das Schaltmittel universell einzusetzen, d.h. für einen Gleichstrom-Betrieb und einen Wechselstrom-Betrieb.

Die Aufgabe wird für das eingangs genannte Schaltmittel dadurch gelöst, dass zwischen den Ausgangsklemmen in einer Reihenschaltung ein erster Feldeffekttransistor, ein erster Widerstand, ein zweiter Widerstand und ein zweiter Feldeffekttransistor angeordnet ist, wobei die Gate-Anschlüsse der Feldeffekttransistoren mit dem ersten Ausgangsanschluss verbunden sind, wobei die Widerstände in einer Reihenschaltung die Source-Anschlüsse der Feldeffekttransistoren verbinden, wobei ein erster Regeltransistor mit seinem Basisanschluss an dem Source-Anschluss und mit seinem Kollektor-Anschluss an den Gate-Anschluss des ersten Feldeffekttransistors angeschlossen ist und mit seinem Emitter-Anschluss an den Source-Anschluss des zweiten Feldeffekttransistors angeschlossen ist, wobei ein zweiter Regeltransistor mit seinem Basisanschluss an dem Source-Anschluss und mit seinem Kollektor-Anschluss an den Gate-Anschluss des zweiten Feldeffekttransistors angeschlossen ist und mit seinem Emitter-Anschluss an dem Source-Anschluss des ersten Feldeffekttransistors angeschlossen ist, wobei der zweite Ausgangsanschluss zwischen dem ersten Widerstand und dem zweiten Widerstand angeschlossen ist, wodurch eine Kurzschlussstrombegrenzung realisiert ist.

Mit dieser Erfindung wird eine Schaltungsanordnung eines Schaltmittels einer universellen potential getrennten Ausgabestufe betrachtet. Im Sinne der Erfindung bezieht sich universell auf die Einsetzbarkeit der Schaltungsanordnung für Gleich- und Wechselstrom. Dieses Schaltmittel ausgestaltet als eine Ausgabestufe, insbesondere für Ausgabebaugruppen der industriellen Automatisierung, kommt ohne eine externe Versorgung aus. Da in einem Laststromstrang zwischen der ersten Ausgangsklemme und der zweiten Ausgangsklemme der erste Feldeffekttransistor und der zweite Feldeffekttransistor mit dem ersten und zweiten Widerstand, welcher jeweils als ein Shunt betrachtet werden, in Serie geschaltet ist und durch die gegensinnige Anordnung der Regeltransistoren, erlaubt diese Schaltungsanordnung einen Betrieb einer Last mit Gleichstrom oder Wechselstrom, also unabhängig von der Polarität. Eine Reduzierung der Schaltungsanordnung auf nur einen ersten Feldeffekttransistor und einen Shunt, ließe nur eine feste Polarität im Gleichstrombetrieb zu.

Damit die Schaltungsanordnung mit dem Schaltmittel bei einem Kurzschluss und somit bei einer steigenden Klemmspannung zwischen der ersten Ausgangsklemme und der zweiten Ausgangsklemme eine Diagnosemeldung generieren kann und eine selbständige Abschaltung der Feldeffekttransistoren vornimmt und dadurch einen vollständigen Kurzschlussschutz bietet, ist ein erster Eingangs-Pin eines Kurzschlussdiagnosemittels über eine erste Diode mit der ersten Ausgangsklemme verbunden und über eine zweite Diode mit der zweiten Ausgangsklemme verbunden und ein zweiter Eingangs-Pin des Kurzschlussdiagnosemittels ist mit dem zweiten Ausgangsanschluss verbunden, wobei das Kurzschlussdiagnosemittel ausgestaltet ist, dass ein Stromfluss über den ersten Eingangs-Pin zum zweiten Eingangs-Pin ein Diagnosesignal generiert.

Um nach einem Abschalten des Stromes an der Schaltsignal-Eingangsseite Schaltverluste möglichst zu minimieren, ist ein Überwachungstransistor mit seinem Gate-Anschluss am ersten Ausgangsanschluss und mit seinem Drain-Anschluss am zweiten Ausgangsanschluss angeschlossen, wobei der Source-Anschluss des Überwachungstransistors zum einen über einen Widerstand mit dem ersten Ausgangsanschluss und zum anderen mit dem Gate-Anschluss des ersten Feldeffekttransistors verbunden ist.

Wenn die Schaltspannung zwischen dem ersten Ausgangsanschluss und dem zweiten Ausgangsanschluss aufgrund einer fehlenden Spannung an der Schaltsignal-Eingangsseite absinkt, wird der Abschaltvorgang eingeleitet.

Wenn die Photodioden des Potentialtrennmittels nicht mehr genügend mit Licht versorgt werden, wird der Überwachungstransistors leitend geschaltet, wobei noch vorhandene elektrische Ladungen aufgrund der Gate-Kapazitäten des ersten Feldeffekttransistors und des zweiten Feldeffekttransistors den Überwachungstransistor leitend halten, wodurch ein schneller Abschaltvorgang realisiert ist und dadurch Schaltverluste minimiert werden.

Vorteilhaft ist es bei der Ausgestaltung des Schaltmittels, dass der zweite Ausgangsanschluss und der Punkt zwischen dem ersten Widerstand und dem zweiten Widerstand einen virtuellen Massepunkt bilden.

Insbesondere im Hinblick auf die Automatisierungstechnik in Fertigungsprozessen wird die eingangs genannte Aufgabe durch eine Ausgabebaugruppe für die industrielle Automatisierung dadurch gelöst, dass ein Schaltmittel nach den Ansprüchen 1 bis 4 vorhanden ist, wobei das Diagnosesignal zur weiteren Auswertung an einen Mikro-Controller geführt ist und das Schaltmittel durch die gegensinnige Anordnung des ersten Regeltransistors zu den zweiten Regeltransistor einen Schaltbetrieb von Wechselstrom oder Gleichstrom erlaubt.

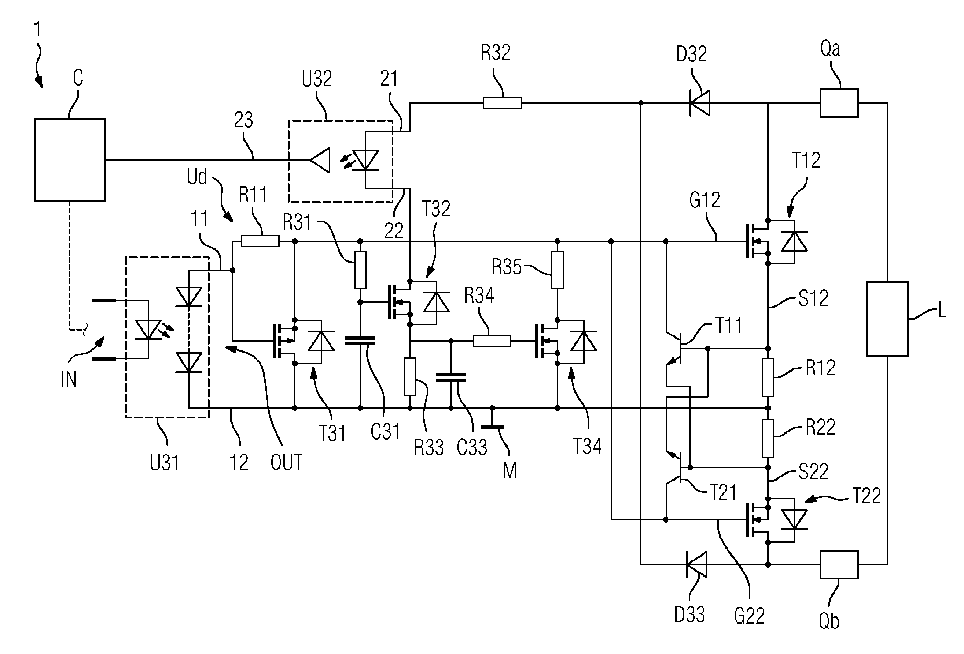

Die Zeichnung zeigt ein Ausführungsbeispiel der Erfindung, wobei die einzige Figur ein erfindungsgemäßes Schaltmittel aufgebaut aus diskreten Bauteilen zeigt.

Gemäß Der Figur ist ein Schaltmittel 1 zum Schalten einer zwischen einer ersten Ausgangsklemme Qa und einer zweiten Ausgangsklemme Qb angeordneten Last L dargestellt. Ein Potentialtrennmittel U31 mit einer Schalt-Signaleingangsseite IN und einer Schalt-Signalausgangsseite OUT ist nach dem Photovoltaikprinzip aufgebaut, wobei durch Anlegen einer Spannung an die Schalt-Signaleingangsseite IN eine Schalt-Spannung Ud an der Schalt-Signalausgangsseite OUT zwischen einem ersten Ausgangsanschluss 11 und einem zweiten Ausgangsanschluss 12 erzeugbar ist. Da sich die Schalt-Spannung Ud aufgrund des Potentialtrennmittels U33 nach dem Photovoltaikprinzip quasi von selbst generiert, kommt das Schaltmittel 1 ohne eine externe Spannungsversorgung aus.

Zwischen der ersten Ausgangsklemme Qa und der zweiten Ausgangsklemme Qb ist in einer Reihenschaltung ein erster Feldeffekttransistor T12, ein erster Widerstand R12, ein zweiter Widerstand R22 und ein zweiter Feldeffekttransistor T22 angeordnet, wobei die Gate-Anschlüsse G12, G22 der Feldeffekttransistoren T12,T22 mit dem ersten Ausgangsanschluss 11 verbunden sind. Die Widerstände R12,R22 liegen in einer Reihenschaltung zwischen den Source-Anschlüssen S12,S22 der Feldeffekttransistoren T12,T22. Ein erster Regeltransistor T11 ist mit seinem Basisanschluss an dem Source-Anschluss S12 und mit seinem Kollektor-Anschluss an den Gate-Anschluss G12 des ersten Feldeffekttransistors T12 angeschlossen. Der erste Regeltransistor T11 ist mit seinem Emitter-Anschluss an dem Source-Anschluss S22 des zweiten Feldeffekttransistors T22 angeschlossen. Ein zweiter Regeltransistor T21 ist quasi gegensinnig zu den ersten Regeltransistor T11 angeschlossen. Der zweite Regeltransistor T21 ist mit seinem Basis-Anschluss an den Source-Anschluss S22 und mit seinem Kollektor-Anschluss an dem Gate-Anschluss G22 des zweiten Feldeffekttransistors T22 angeschlossen und mit seinem Emitter-Anschluss an dem Source-Anschluss S12 des ersten Feldeffekttransistors T22 angeschlossen. Der zweite Ausgangs-Anschluss 12 ist zwischen dem ersten Widerstand R12 und dem zweiten Widerstand R22 angeschlossen, wodurch eine Kurzschlussstrombegrenzung realisiert ist, wie im Folgenden näher erläutert.

In den Laststromstrang, also den Pfad, der zwischen der ersten Ausgangsklemme Qa und der zweiten Ausgangsklemme Qb gebildet ist, sind die zwei Feldeffekttransistoren T12,T22 und die zwei als Shunts ausgebildeten Widerstände R12 und R22 in Serie geschaltet. Diese gegensinnige Anordnung erlaubt mit dem ersten Regeltransistor T11 und dem zweiten Regeltransistor T21 einen AC- und DC-Betrieb, welcher unabhängig von der Polarität ist. Eine Reduzierung der Schaltungsanordnung auf nur einen Feldeffekttransistor und nur einen Shunt lässt nur einen mit fester Polarität, nämlich einen DC-Betrieb zu.

Die Source-Anschlüsse der beiden Feldeffekttransistoren T12,T22 sind über die Shunts (erster Widerstand R12, zweiter Widerstand R22) mit einer virtuellen Masse M der Schaltung verbunden.

Die an der Schaltsignal-Ausgangsseite OUT des Potentialtrennmittels U31 generierte Schaltspannung Ud, wird den Gate-Anschlüssen der beiden Feldeffekttransistoren T12 und T22 als Schaltspannung zugeführt. Dadurch Schalten die Feldeffekttransistoren T12 und T22 in einen niederohmigen Zustand. Würde die Schaltspannung Ud weggenommen werden, schalten die beiden Feldeffekttransistoren T12 und T22 in einen hochohmigen Zustand. Das Schalten der Last L erfolgt somit mit einem Signal an der Schalt-Signaleingangsseite IN des Potentialtrennmittels U31. Der Zustand der beiden Feldeffekttransistoren T12 und T22 ist unabhängig von der zwischen den Ausgangsklemmen Qa,Qb angelegten Spannung.

Ein Vorteil dieser Schaltungsanordnung besteht darin, dass die beschriebene Schaltungsanordnung keine zusätzliche Versorgung, beispielsweise über einen DC-Wandler benötigt, da die Schaltungsanordnung das Potentialtrennmittel U31 aufweist, welches nach dem Photodioden-Treiberprinzip arbeitet. Es liefert demnach im aktivierten Zustand genügend Energie zum Ansteuern der Gate-Anschlüsse der Feldeffekttransistoren T12 und T22.

Ein weiterer Vorteil der Schaltungsanordnung gemäß der Figur ist es, dass bei einem Kurzschluss und steigender Klemmenspannung zwischen den Ausgangsklemmen Qa,Qb eine Diagnosemeldung generiert wird und ein selbständiges Abschalten der Feldeffekttransistoren T12 und T22 durchgeführt wird und damit ein vollständiger Kurzschlussschutz geboten ist. Die Energie für die Bildung der Diagnosemeldung wird dem Lastkreis entnommen.

Im Kurzschlussfall (im eingeschalteten Zustand) bildet sich durch den hohen Kurzschlussstrom ein Spannungsabfall an dem ersten Widerstand R12 und dem zweiten Widerstand R22. Entweder der erste Regeltransistor T11 oder der zweite Regeltransistor T21 beginnt je nach Polarität zu leiten und reduziert damit die Gate-Spannung der Feldeffekttransistoren T12,T22, der Kurzschlussstrom wird dadurch begrenzt bzw. geregelt.

In einem Kurzschlussfall steigt nicht nur der Strom durch die Last an, sondern es steigt auch die Spannung zwischen der ersten Ausgangsklemme Qa und der zweiten Ausgangsklemme Qb an, dadurch kann von der ersten Ausgangsklemme Qa bzw. der zweiten Ausgangsklemme Qb, je nach Polarität, ein Strom über die erste Diode D32 oder die zweite Diode D33, den Widerstand R32, die LED des Kurzschlussdiagnosemittels U32, den Transistor T32 und den Widerstand R33 zur virtuellen Masse M und weiter zur zweiten Ausgangsklemme Qb fließen. Der Stromfluss über die LED des Kurzschlussdiagnosemittels U32 generiert ein Diagnosesignal 23. Dieses Diagnosesignal 23 wird an einen Mikrocontroller C zur weiteren Auswertung weitergeleitet. Der Spannungsabfall an dem Widerstand R33 bringt den Transistor T34 zum Leiten. Als Folge davon wird die Gate-Spannung der Feldeffekttransistoren T12 und T22 soweit verringert, dass diese Transistoren in den hochohmigen Zustand schalten. Der Kurzschlussstrom im Lastkreis wird unterbrochen.

Nach der Erkennung des Diagnosesignals 23 schaltet der Mikro-controller C die Ansteuerung der LED des Potentialtrennmittels U31 ab. Die Ansteuerung des Schaltmittels 1 wird somit abgeschaltet.

Ein Kondensator C33 bildet mit einem Widerstand R34 einen Tiefpassfilter, der von einer Seite eine falsche Reaktion bei einer Störung verhindert und von der anderen Seite eine Verzögerung, welche beim Anschalten wirksam ist, realisiert.

Durch den Eingangsstrom auf der Schaltsignal-Eingangsseite IN wird auf der Schaltsignal-Ausgangsseite OUT eine Spannung erzeugt. Diese Spannung wird den Gates der Feldeffekttransistoren T12 und T22 als Schaltspannung zugefügt. Gleichzeitig wird ein Kondensator C31 aufgeladen und die Gate-Spannung des Transistors T32 steigt. Die Drain-Source-Strecke des Transistors T32 wird niederohmig. Nach dem die Einschaltphase zu Ende ist, fällt an dem Drain-Anschluss des ersten Feldeffekttransistors T12 bzw. des zweiten Feldeffekttransistors T22 eine niedrige Spannung ab, so dass praktisch kein Strom über die erste Diode D32 bzw. die zweite Diode D33 fließt. Dann fließt auch kein Strom über den Widerstand R33, die LED des Kurzschluss-Diagnosemittel U32, den Transistor T32 und den Widerstand R33. An dem Widerstand R33 fällt also keine Spannung ab, wodurch der Transistor T34 gesperrt bleibt. Nach einem Beenden des Einschaltvorgangs fließen nur Restströme (Leck-Ströme), die die Photodioden in den Potentialtrennmittel U31 kaum belasten. Nach dem Abschalten der Spannung an der Schaltsignal-Eingangsseite IN sinkt die Spannung in den Photodioden des Potentialtrennmittels U31. Die sinkende Photodioden-Spannung und noch vorhandene elektrische Ladungen aus den Gate-Kapazitäten des ersten Feldeffekttransistors T12 und des zweiten Feldeffekttransistors T22 und einer Ladung auf den Kondensator C31, bringen den Transistor T31 zum Leiten, wodurch die oben erwähnten Kapazitäten schnell entladen werden. Ein Abschaltvorgang wird dadurch deutlich beschleunigt, wodurch Schaltverluste minimiert werden. Weiterhin ist es von Vorteil, dass die so geschaffene universelle potentialgetrennte Schaltungsanordnung in einem breiten Lastspannungsbereich arbeiten kann. Die Anordnung des Transistors T32 und des Widerstandes R32 in Zusammenschau mit der erzeugten Schaltspannung Ud des Universaltrennmittels U31 bildet eine Stromquelle. Das Kurzschluss-Diagnosemittel U32, welches die Diagnose über das Diagnosesignal 23 weiter gibt, wird also mit diesem von der Lastspannung unabhängigen Strom betrieben.

Die RC-Kombination aus dem Widerstand R31 und dem Kondensator C31 am Gate des Transistors T32 verhindert die Generierung des Diagnosesignals 23 in einer Einschaltphase, in der die Spannung zwischen der ersten Ausgangsklemme Qa und der zweiten Ausgangsklemme Qb noch hoch ist, aber kein Kurzschluss vorliegt.

Mit der Erfindung wird eine Schaltungsanordnung mit einer bestimmten Anordnung an bipolaren Feldeffekttransistoren betrachtet. Auch eine andere Kombination der bipolaren Feldeffekttransistoren als auch ein Tausch der Typen von N- auf P-Kanal bzw. von P- auf N-Kanal und umgekehrt ist mit der Erfindungsidee abgedeckt.

## Patentansprüche

1. Schaltmittel (1) zum Schalten einer zwischen einer ersten Ausgangsklemme (Qa) und einer zweiten Ausgangsklemme (Qb) angeordneten Last (L), umfassend
ein Potentialtrennmittel (U31) mit einer Schaltsignal-Eingangsseite (IN) zur Trennung des Potentials zwischen der Schaltsignal-Eingangsseite (IN) und einer Schaltsignal-Ausgangsseite (OUT), wobei das Potentialtrennmittel (U31) nach dem Photovoltaikprinzip aufgebaut ist und durch Anlegen einer Spannung an die Schaltsignal-Eingangsseite (IN) eine Schalt-Spannung (Ud) an der Schaltsignal-Ausgangsseite (OUT) zwischen einem ersten Ausgangsanschluss (11) und einem zweiten Ausgangsanschluss (12) erzeugbar ist,
**dadurch gekennzeichnet, dass** zwischen den Ausgangsklemmen (Qa,Qb) in einer Reihenschaltung ein erster Feldeffekttransistor (T12), ein erster Widerstand (R12), ein zweiter Widerstand (R22) und ein zweiter Feldeffekttransistor (T22) angeordnet ist, wobei die Gate-Anschlüsse (G12, G22) der Feldeffekttransistoren (T12,T22) mit dem ersten Ausgangsanschluss (11) verbunden sind, wobei die Widerstände (R12, R22) in einer Reihenschaltung die Source-Anschlüsse (S12, S22) der Feldeffekttransistoren (T12, T22) verbinden, wobei ein erster Regeltransistor (T11) mit seinem Basisanschluss an dem Source-Anschluss (S12) und mit seinem Kollektor-Anschluss an dem Gate-Anschluss (G12) des ersten Feldeffekttransistors (T12) angeschlossen ist und mit seinem Emitter-Anschluss an dem Source-Anschluss (S22) des zweiten Feldeffekttransistors (T22) angeschlossen ist, wobei ein zweiter Regeltransistor (T21) mit seinem Basisanschluss an dem Source-Anschluss (S22) und mit seinem Kollektor-Anschluss an dem Gate-Anschluss (G22) des zweiten Feldeffekttransistors (T22) angeschlossen ist und mit seinem Emitter-Anschluss an dem Source-Anschluss (S12) des ersten Feldeffekttransistors (T22) angeschlossen ist, wobei der zweite Ausgangsanschluss (12) zwischen dem ersten Widerstand (R12) und dem zweiten Widerstand (R22) angeschlossen ist, wodurch eine Kurzschlussstrombegrenzung realisiert ist.

2. Schaltmittel (1) nach Anspruch 1, wobei ein erster Eingangs-Pin (21) eines Kurzschlussdiagnosemittels (U32) über eine erste Diode (D32) mit der ersten Ausgangsklemme (Qa) verbunden ist und über eine zweite Diode (D33) mit der zweiten Ausgangsklemme (Qb) verbunden ist und ein zweiter Eingangs-Pin (22) des Kurzschlussdiagnosemittels (U32) mit dem zweiten Ausgangsanschluss (12) in Verbindung steht, wobei das Kurzschlussdiagnosemittel (U32) ausgestaltet ist, dass ein Stromfluss über den ersten Eingangs-Pin (21) zum zweiten Eingangs-Pin (22) ein Diagnosesignal (23) generiert.

3. Schaltmittel (1) nach Anspruch 1 oder 2, ausgestaltet, dass wenn die Schalt-Spannung (Ud) zwischen dem ersten Ausgangsanschluss (11) und dem zweiten Ausgangsanschluss (12) aufgrund einer fehlenden Spannung an der der Schaltsignal-Eingangsseite (IN) absinkt, ein Abschaltvorgang für die Last (L) beschleunigt wird, wobei dafür ein Überwachungstransistor (T31) mit seinem Gate-Anschluss am ersten Ausgangsanschluss (11) und mit seinem Drain-Anschluss am zweiten Ausgangsanschluss (12) angeschossen ist, wobei der Source-Anschluss des Überwachungstransistors (T31) zum einen über einen Widerstand (R11) mit dem ersten Ausgangsanschluss (11) und zum anderen mit dem Gate-Anschluss (G12) des ersten Feldeffekttransistors (T12) verbunden ist.

4. Schaltmittel (1) nach einem der Ansprüche 1 bis 3, wobei der zweite Ausgangsanschluss (12) und der Punkt zwischen dem ersten Widerstand (R12) und dem zweiten Widerstand (R22) einen virtuellen Massepunkt (M) bilden.

5. Ausgabebaugruppe für die industrielle Automatisierung mit einem Schaltmittel (1) nach einem der Ansprüche 1 bis 4, wobei das Diagnosesignal (23) zur weiteren Auswertung an einen Mikrocontroller (C) geführt ist und das Schaltmittel (1) durch die gegensinnige Anordnung des ersten Regeltransistors (T11) zu dem zweiten Regeltransistor (T12) einen Schaltbetrieb von Wechselstrom oder Gleichstrom erlaubt.
